(19) Europäisches Patentamt
European Patent Office
Office européen des brevets

(11) **EP 2 197 031 A1**

(12) **EUROPEAN PATENT APPLICATION**
published in accordance with Art. 153(4) EPC

(43) Date of publication:
**16.06.2010 Bulletin 2010/24**

(51) Int Cl.:
*H01L 27/14* (2006.01)   *G02B 3/00* (2006.01)
*H04N 5/225* (2006.01)   *H04N 5/335* (2006.01)

(21) Application number: **08835866.8**

(22) Date of filing: **02.10.2008**

(86) International application number:
**PCT/JP2008/002773**

(87) International publication number:
**WO 2009/044550 (09.04.2009 Gazette 2009/15)**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **05.10.2007 JP 2007262395**

(71) Applicant: **Panasonic Corporation
Kadoma-shi
Osaka 571-8501 (JP)**

(72) Inventors:
• **TOKUDA, Kimio
Osaka 540-6207 (JP)**
• **ONOZAWA, Kazutoshi
Osaka 540-6207 (JP)**

(74) Representative: **Grünecker, Kinkeldey,
Stockmair & Schwanhäusser
Anwaltssozietät
Leopoldstrasse 4
80802 München (DE)**

(54) **CAMERA MODULE AND CAMERA MODULE MANUFACTURING METHOD**

(57)    A small-sized and low-height camera module is provided.

A camera module 100 includes a solid-state imaging device 1 and an imaging lens which is joined so as to have a gap between the lens and the solid-state imaging device 1. The imaging lens is configured to form a refractive index distribution 3 of a concentric circle structure so as to converge light on the image pickup area of the solid-state imaging device 1.

# FIG. 1

**Description**

Technical Field

The present invention relates to a small and thin type camera module and a method of manufacturing the camera module.

Background Art

In recent years, due to the demand for thinning of a camera-equipped mobile phone or the like, the demand for thinning of a camera module has also increased. A camera module mounted on a camera-equipped mobile phone or the like includes a solid-state imaging device (image sensor), an infrared ray cutoff filter, a substrate, passive parts, an imaging lens or the like. In order to miniaturize and thin the camera module, it is important to miniaturize a sensor chip and the passive parts and reduce the height of an optical system.

As to the miniaturization, the miniaturization of the camera module has become possible on the benefit of the development of the mounting technique such as the mounting technique using a substrate having the same size as the sensor chip (CSP: Chip Scale Package) and the miniaturization of the passive parts. On the other hand, the reduction of the height of the optical system is not easy since it is required to build up optical parts such as IR cutoff filter, a diaphragm and an optical lens on the sensor chip.

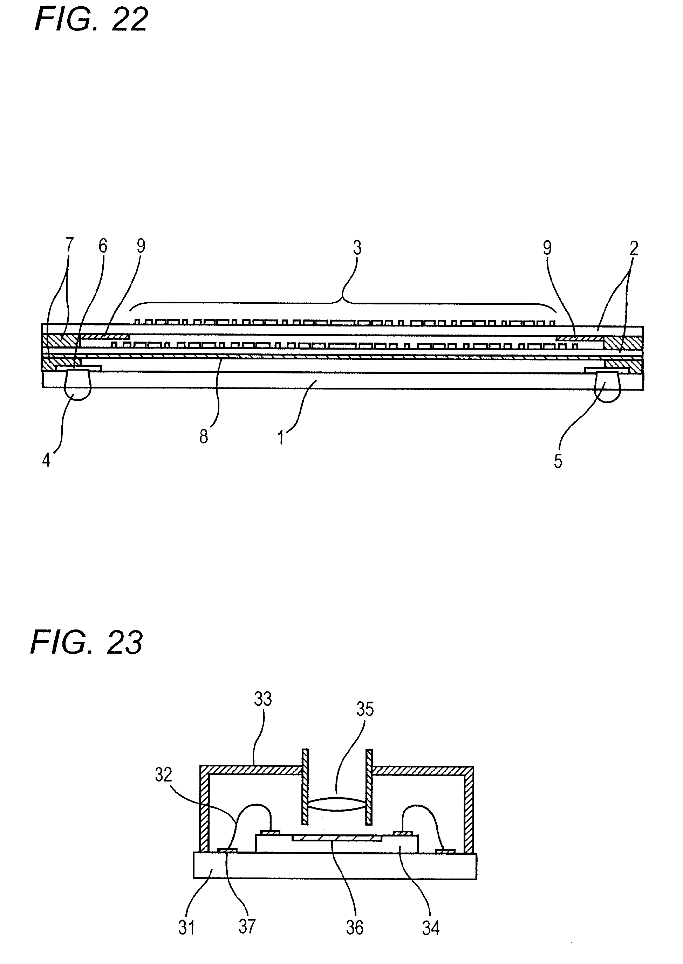

For example, a configuration shown in Fig. 23 is known as a camera module of a related art. This camera module is configured by a substrate 31, a wire 32, a lens holder 33, a solid-state imaging device 34 (image sensor) forming an imaging portion, a lens 35, a light receiving portion 36 and a wiring portion 37. The solid-state imaging device 34 is electrically coupled with the wiring on the substrate via the wire 32. This camera module has the lens holder 33 for assembling the lens 35 above the light receiving portion 36 without contacting with the wire.

In this manner, since the camera module of the related art requires the lens holder 33, the substrate 31, the solid-state imaging device 34, sealing resin for sealing such the stacked members, or the like., it is not only difficult to assemble the respective parts but also difficult to realize a small and low-height camera module.

Thus, following structures related to thinning the camera module have been proposed.

The first camera module is configured to include a transmissive substrate on one surface of which a wiring portion is formed and a lens is formed at a non-wiring portion, and a solid-state imaging device (image sensor) having an imaging portion. The imaging portion faces the lens portion and the solid-state imaging device is coupled to the wiring portion via a bump (see a patent document 1, for example). Thus, the increase of the thickness due to the wiring portion can be suppressed. Further, since the lens and a lens holder portion are formed within the substrate, the increase of the height of the module due to the increase of the thickness of the substrate can be suppressed. Furthermore, since the number of lens related parts such as the lens holder can be reduced, the manufacturing can be facilitated and the number of the manufacturing processes can be reduced, whereby the manufacturing cost can be suppressed.

The second camera module includes a groove portion penetrating from a rear surface to a front surface, a substrate having a plurality of ball bumps, coupling terminals provided on the substrate so as to be exposed from the groove portion, a solid-state imaging device (semiconductor chip) having an imaging portion, a lens sheet provided on the solid-state imaging device and having an imaging lens portion, and a conductive pattern formed on the substrate and electrically coupling the coupling terminals and the ball bumps (see a patent document 2, for example).

Patent Document 1: JP-A-2003-125294
Patent Document 2: JP-A-2007-12995

Disclosure of the Invention

Problems that the Invention is to Solve

However, according to the technique of the patent document 1, since the lens and the wiring portion are formed in the same substrate, it is difficult to suppress the increase of the projection area of the camera module and so it is difficult to miniaturize the camera module. Also, further stacking of the lens is difficult.

According to the technique of the patent document 2, it is difficult to laminate the lens sheet on a semiconductor wafer uniformly and without causing any deformation. In case where any deformation arises, lens aberration appears and the imaging performance is degraded. Further, according to this method, since only one lens face can be prepared, it is difficult to prepare a camera module with a high image-pickup performance. Further, it is difficult to further laminate the lens.

The invention is made in view of the aforesaid circumstances and an object of the invention is to provide a small and low-height camera module and a method of manufacturing the camera module.

Means for Solving the Problems

In order to achieve the aforesaid object, the first camera module according to the invention includes: a solid-state imaging device; and an imaging lens which is bonded with the solid-state imaging device so as to have a gap therebetween. The imaging lens has a refractive index distribution which is arranged concentrically, wherein the refractive index distribution collect an incident light on an imaging area of the solid-state imaging device.

Thereby, the imaging lens can be formed with an almost same size as the solid-state imaging device (semiconductor chip), and so the camera module can be miniaturized. Further, since the imaging lens is formed so as to have the refractive index distribution, the imaging lens becomes quite thin and the height thereof can be low.

Further, in the second camera module according to the invention, the imaging lens has a combination of a plurality of concentric circular convex structure on a substrate.

Thereby, the imaging lens can be formed with an almost same size as the solid-state imaging device, and so the camera module can be miniaturized. Further, since the refractive index distribution configured by the convex portions of the concentric circular shape is formed on the surface of the substrate to thereby constitute the imaging lens, the imaging lens becomes quite thin and the height thereof can be low.

Further, in the third camera module according to the invention, the imaging lens has a combination of a plurality of concentric circular light transmissive film pattern on a substrate.

Thus, the imaging lens can be formed with an almost same size as the solid-state imaging device, and so the camera module can be miniaturized. Further, since the refractive index distribution configured by the pattern of the light transmissive film is formed on the surface of the substrate to thereby constitute the imaging lens, the imaging lens becomes quite thin and the height thereof can be low.

Further, in the fourth camera module according to the invention, the substrate includes a first glass layer and a second glass layer, wherein a melting point of the second glass layer lower than that of the first glass layer.

Thus, the refractive index distribution can be formed easily on the substrate by nano-imprinting technique or the like.

Further, in the fifth camera module according to the invention, the imaging lens is configured by the substrate and thermoset resin pasted on the substrate.

Thus, the refractive index distribution can be formed easily on the substrate by the nano-imprinting technique or the like.

Further, in the sixth camera module according to the invention, the imaging lens is configured by the substrate and UV-curing resin pasted on the substrate.

Thus, the refractive index distribution can be formed easily on the substrate by the nano-imprinting technique etc.

Further, in the seventh camera module according to the invention, the concentric circular convex structure is formed by imprinting on the surface of the imaging lens.

Thus, the refractive index distribution can be formed easily on the substrate by the nano-imprinting technique or the like.

Further, in the eighth camera module according to the invention, the gap has a sealed structure.

Thus, since the gap between the solid-state imaging device and the imaging lens is sealed, dust can be prevented from adhering to the imaging portion of the solid-state imaging device.

Further, in the ninth camera module according to the invention, the gap is filled with inert gas.

Thus, dew is prevented from being formed at the camera module even if the camera module is placed under a low temperature circumstance.

Further, in the tenth camera module according to the invention, the gap is in a vacuum state.

Thus, dew is prevented from being formed at the camera module even if the camera module is placed under a low temperature circumstance.

Further, in the eleventh camera module according to the invention, the imaging lens includes two or more of the substrates, and refractive index distributions formed on the respective substrates differ.

Thus, a plurality of lens surfaces can be formed and so the camera module with a high imaging performance can be manufactured.

Further, in the twelfth camera module according to the invention, the imaging lens includes an infrared ray cutoff filter on a surface of the substrate opposing to the solid-state imaging device.

Thus, since the infrared ray cutoff filter can be formed on the substrate configuring the lens, the height of the camera module can be lowered. Further, since the filter is formed on the flat surface of the substrate, the filter can be formed easily and the characteristics thereof are stable.

Further, in the thirteenth camera module according to the invention, the imaging lens includes an infrared ray cutoff filter which is formed between the substrate and the pattern of the light transmissive film.

Thus, since the infrared ray cutoff filter can be formed on the substrate configuring the lens, the height of the camera module can be lowered. Further, since the filter is formed on the flat surface of the substrate, the filter can be formed easily and the characteristics thereof are stable.

Further, in the fourteenth camera module according to the invention, the imaging lens has a light shielding layer on a surface of the substrate opposing to the solid-state imaging device.

Thus, since the diaphragm of the imaging system can be formed by the light shielding area, the height of the camera module can be lowered.

Further, in the fifteenth camera module according to the invention, through-hole electrodes are formed on the solid-state imaging device.

Thus, since coupling terminals can be formed on the lower surface, for example, of the solid-state imaging device (semiconductor chip), the camera can be miniaturized.

The first method of manufacturing a camera module according to the invention is a method of manufacturing a camera module which includes a solid-state imaging device, and an imaging lens which is bonded with the solid-state imaging device so as to have a gap therebetween, wherein the imaging lens has a refractive index distribution which is arranged concentrically, wherein the refractive index distribution collect an incident light on an imaging area of the solid-state imaging device, the method including the step of: forming the refractive index distribution of the imaging lens after bonding the substrate of the imaging lens and the solid-state imaging device.

Thus, the imaging lens can be formed with an almost same size as the solid-state imaging device (semiconductor chip), and so the camera module can be miniaturized. Further, since the imaging lens is formed by the refractive index distribution, the imaging lens becomes quite thin and the height thereof can be low. Further, since the refractive index distribution is formed after bonding the substrate of the imaging lens and the solid-state imaging device (semiconductor chip), the generation of the aberration of the lens can be suppressed even if any deformation arises due to the bonding.

The second method of manufacturing a camera module according to the invention is a method of manufacturing a camera module which includes a solid-state imaging device, and an imaging lens which is bonded with the solid-state imaging device so as to have a gap therebetween, wherein the imaging lens has a refractive index distribution which is arranged concentrically, wherein the refractive index distribution collect an incident light on an imaging area of the solid-state imaging device, the method including the step of: bonding the substrate of the imaging lens and the solid-state imaging device after forming the refractive index distribution on the substrate of the imaging lens.

Thus, the imaging lens can be formed with an almost same size as the solid-state imaging device (semiconductor chip), and so the camera module can be miniaturized. Further, since the refractive index distribution configured by the convex portions of the concentric circular shape is formed on the surface of the substrate to thereby constitute the imaging lens, the imaging lens becomes quite thin and the height thereof can be low.

Further, in the third method of manufacturing the camera module according to the invention, at a time of forming the refractive index distribution of the imaging lens, the method comprising the step of: coating a resin on the substrate; and imprinting the resin.

Thus, the refractive index distribution can be formed easily on the substrate by the nano-imprinting technique etc.

Further, in the fourth method of manufacturing the camera module according to the invention, the substrate includes a first glass layer and a second glass, wherein a melting point of the second glass layer lower than that of the first glass layer, and wherein at a time of forming the refractive index distribution of the imaging lens, the method comprising the step of: heating the substrate to a temperature equal to or higher than the melting point of the second glass layer; and imprinting the second glass layer.

Thus, the refractive index distribution can be formed easily on the substrate by the nano-imprinting technique etc.

Effects of the Invention

According to the camera module of the invention, even if the camera module is miniaturized and the height of the camera module is lowered, the aberration of an imaging optical system can be suppressed and an imaging with a high resolution is possible.

Brief Description of the Drawings

Fig. 1 is a diagram showing an example of the basic configuration of a camera module according to the first embodiment of the invention.
Fig. 2 is a schematic sectional diagram showing an example of the refractive index distribution formed on a substrate according to the first embodiment of the invention.

Fig. 3 is a schematic top diagram showing the example of the refractive index distribution formed on the substrate according to the first embodiment of the invention.

Fig. 4 is a schematic sectional diagram showing an example of a SELFOC lens according to the first embodiment of the invention.

Fig. 5 is a diagram showing an example of the refractive index distribution of the SELFOC lens according to the first embodiment of the invention.

Fig. 6 is a diagram showing an example of the phase difference distribution of the SELFOC lens according to the first embodiment of the invention.

Fig. 7 is a schematic sectional diagram showing an example of a lens using a light transmissive film according to the first embodiment of the invention.

Fig. 8A is a diagram showing an example of the lens using the transmissive film to convert into a Fresnel-type profile of refractive index distribution according to the first embodiment of the invention, and Fig. 8B is an enlarged diagram showing the example of the lens using the light transmissive to convert into a Fresnel-type profile of refractive index distribution according to the first embodiment of the invention.

Fig. 9 is a diagram showing an example of the simulation result of light rays of an optical system according to the first embodiment of the invention.

Fig. 10 is a diagram showing an example of the simulation result of light rays of the optical system according to the first embodiment of the invention.

Fig. 11 is a diagram showing an example of the simulation result of light rays of the optical system according to the first embodiment of the invention.

Fig. 12 is a diagram showing an example of the simulation result of light rays of the optical system according to the first embodiment of the invention.

Fig. 13A is a schematic diagram showing an example of sectional structure of a semiconductor wafer according to the first embodiment of the invention, and Fig. 13B is a schematic top view showing the example of the semiconductor wafer according to the first embodiment of the invention.

Fig. 14A is a schematic diagram showing the example of the sectional structure of the semiconductor wafer according to the first embodiment of the invention, and Fig. 14B is the schematic top view showing the example of the semiconductor wafer according to the first embodiment of the invention.

Fig. 15A is a schematic diagram showing the example of the sectional structure of the semiconductor wafer according to the first embodiment of the invention, and Fig. 15B is the schematic top view showing the example of the semiconductor wafer according to the first embodiment of the invention.

Fig. 16A is a schematic diagram showing the example of the sectional structure of the semiconductor wafer according to the first embodiment of the invention, and Fig. 16B is the schematic top view showing the example of the semiconductor wafer according to the first embodiment of the invention.

Fig. 17A is a schematic diagram showing the example of the sectional structure of the semiconductor wafer according to the first embodiment of the invention, and Fig. 17B is the schematic top view showing the example of the semiconductor wafer according to the first embodiment of the invention.

Fig. 18 is a diagram showing an example of another configuration of the camera module according to the first embodiment of the invention.

Fig. 19 is a diagram showing an example of still another configuration of the camera module according to the first embodiment of the invention.

Fig. 20 is a diagram showing an example of configuration of a camera module according to the second embodiment of the invention.

Fig. 21 is a diagram showing an example of another configuration of the camera module according to the second embodiment of the invention.

Fig. 22 is a diagram showing an example of still another configuration of the camera module according to the second embodiment of the invention.

Fig. 23 is a diagram showing the configuration of a camera module of a related art.

Explanation of Signs

| 1 | image sensor |
|---|---|
| 2 | transparent substrate |
| 3 | refractive index distribution |
| 4 | ball bump |
| 5 | through-hole electrode |

| 6 | electrode terminal |
|---|---|
| 7 | spacer rib |
| 8 | infrared ray cutoff filter |
| 9 | light shielding layer (diaphragm) |
| 21 | radius difference |
| 22 | circumferential difference |
| 31 | substrate |
| 32 | wire |
| 33 | lens holder |
| 34 | sensor |
| 35 | lens |
| 36 | light receiving portion |
| 37 | wiring portion |
| 100, 100B | camera module |

Best Mode for Carrying Out the Invention

Hereinafter, the embodiments according to the invention will be explained concretely with reference to the drawings. Although the invention is explained by using the following embodiments and attached drawings, these embodiments and drawings are intended to show examples and the invention is not limited thereto.

(First Embodiment)

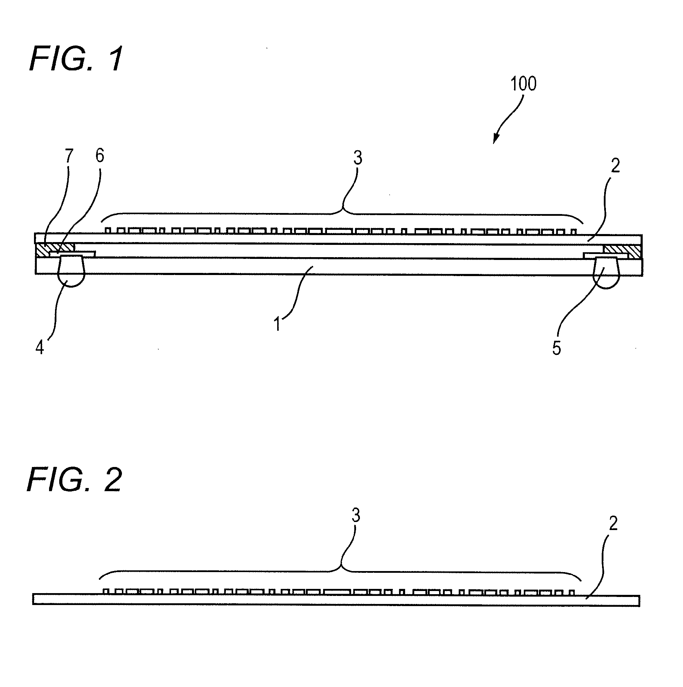

Fig. 1 is a diagram showing an example of the schematic sectional configuration of a camera module 100 according to the first embodiment of the invention. The camera module 100 is a camera module applied to a camera-equipped mobile phone or the like. The camera module 100 includes a solid-state imaging device (image sensor) 1, a transparent substrate 2, a refractive index distribution 3, ball bumps 4, electrode terminals 6 and spacer ribs 7. An imaging lens is configured by the transparent substrate 2 and the refractive index distribution 3.

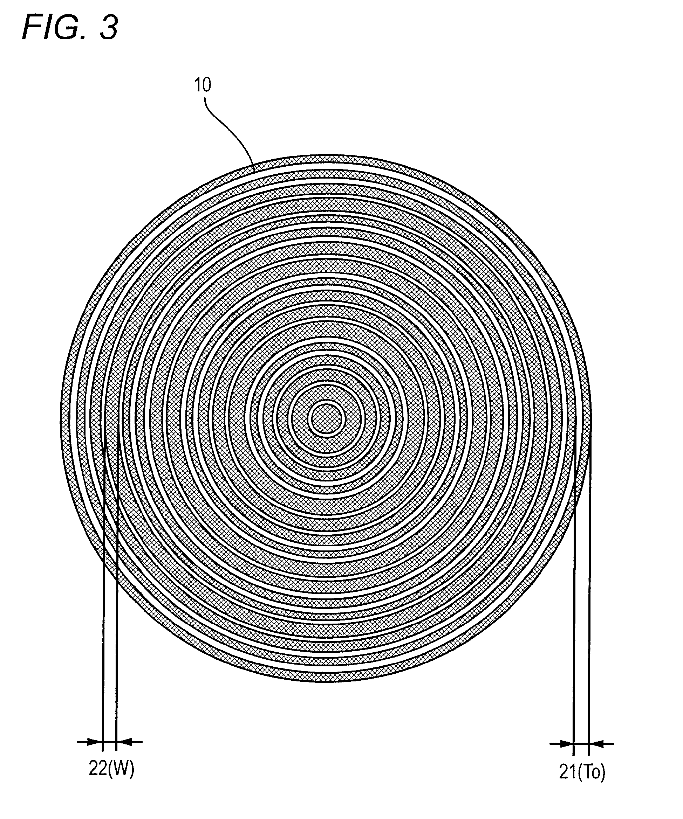

Fig. 2 is a schematic sectional diagram showing an example of the refractive index distribution 3 formed by light transmissive films 10 on the transparent substrate 2. Further, Fig. 3 is a schematic diagram showing an example of the upper surface of the refractive index distribution 3 formed by the light transmissive films 10 on the transparent substrate 2. As shown in Fig. 3, the imaging lens of the camera module 100 is configured by the light transmissive films 10 (glass (n = 1.45)) having the refractive index distribution 3 shown by a concentric circle structure, for example, and the air (n = 1.0). In Fig. 3, a radius difference (To) 21 of the outer circumferences between the adjacent circular light transmissive films 10 is 200 nm and the film thickness of the light transmissive film 10 is 1.2 $\mu$m.

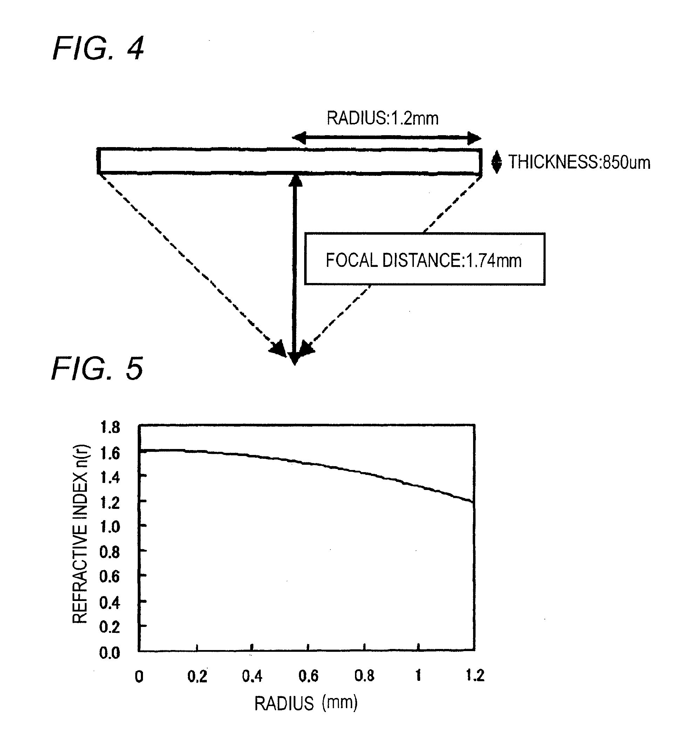

First, as shown in Fig. 4, the lens is designed so as to be a SLFOC lens under the assumption that the radius of the lens is 1,200 $\mu$m, the thickness of the glass material is 850 $\mu$m and the focal distance of the lens is 1,740 $\mu$m.

The refractive index distribution 3 of the glass material of the SELFOC lens has the characteristics shown in Fig. 5, which can be represented by the following expression (1).

[Numeral 1]

$$n\,(r) = n0 \cdot (1 - \alpha^2 \cdot r^2/2) \ ----- \quad (1)$$

$$n0 = 1.6075 \qquad ------------- (2)$$

$$\alpha = 0.608 \qquad ----------------- (3)$$

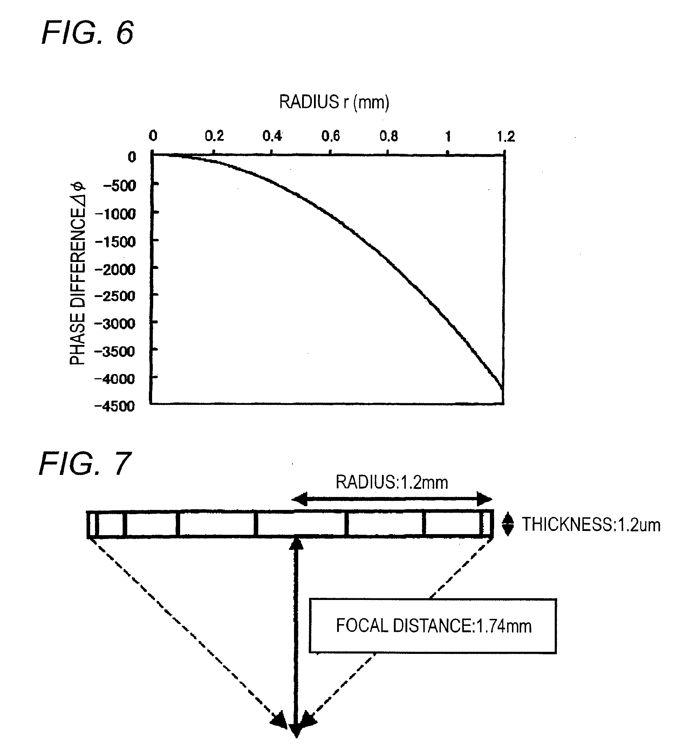

The phase difference distribution of the glass material of the SELFOC lens has the characteristics shown in Fig. 6, which can be represented by the following expression.

$$\Delta\varphi = -\,2\pi \cdot (n - n\,(r))\ d/\lambda$$

$$d = 850 \ \mu\text{m}, \ \lambda = 540 \ \text{nm}$$

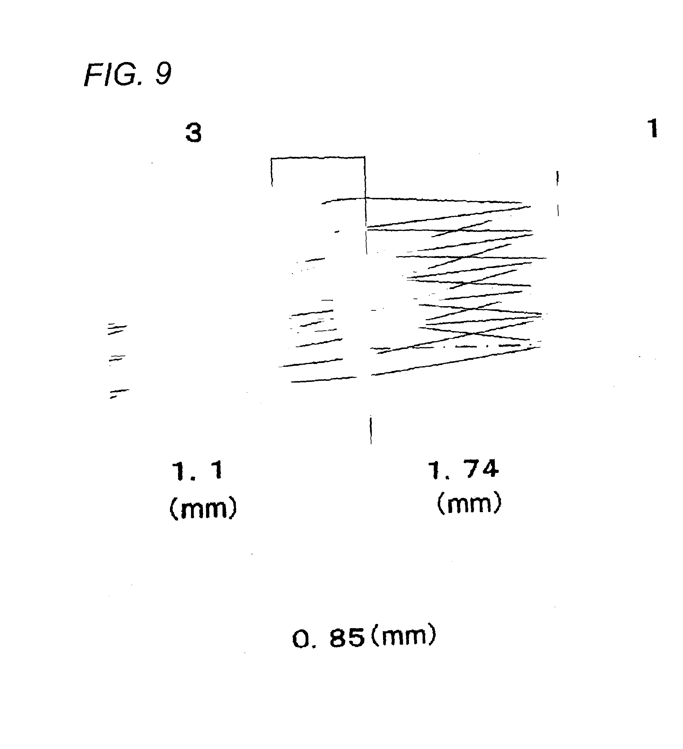

Next, the explanation will be made as to an example of the designing results of the SELFOC lens. Fig. 9 is a diagram showing an example of the optical path of the imaging lens configured by the refractive index distribution 3. From Fig. 9, it will be understood that the imaging lens configured by the refractive index distribution 3 is designed so as to converge light on the imaging area of the solid-state imaging device 1 and so an image formation plane locates at the image pickup area of the solid-state imaging device 1.

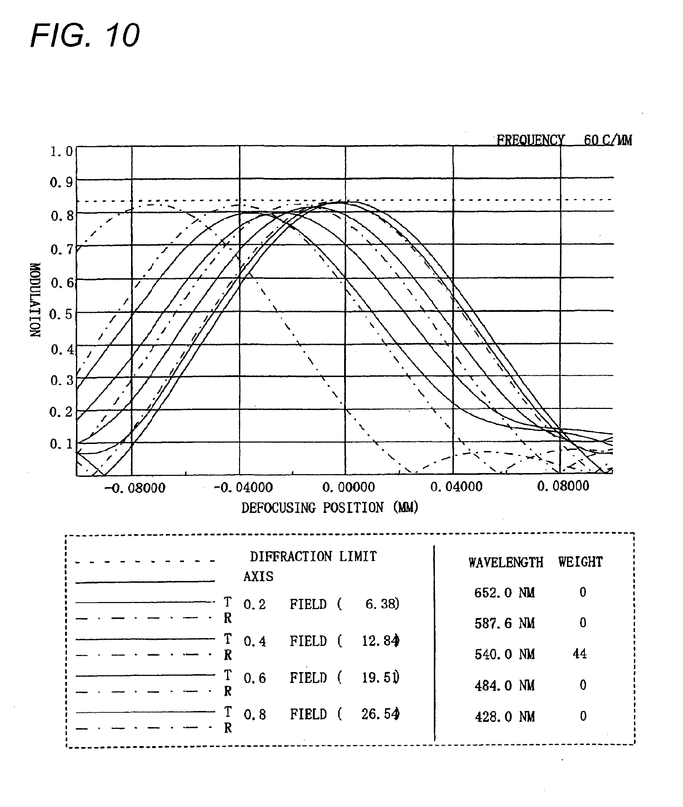

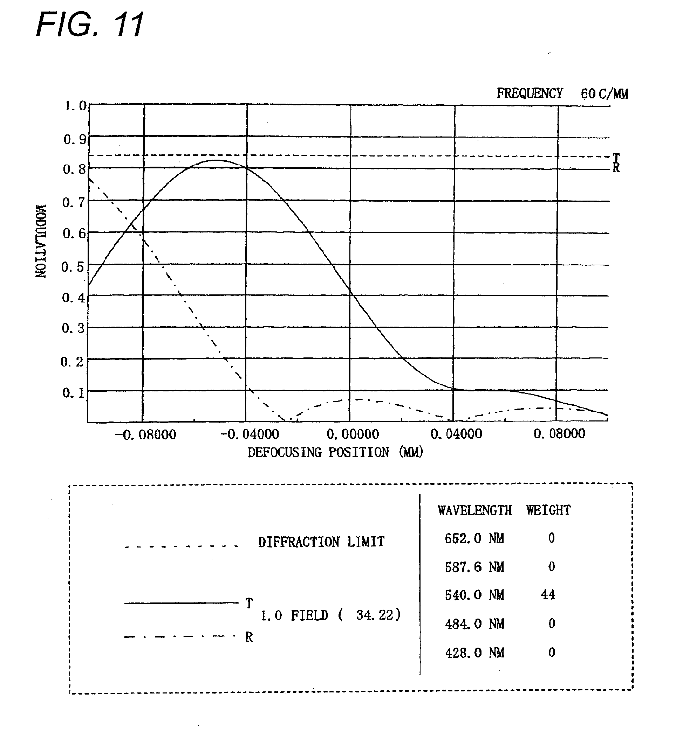

Fig. 10 is a diagram showing an example of the MTF (de-focusing characteristics: image height in a rage of 0 to 80%) of the imaging lens configured by the refractive index distribution 3. Fig. 11 is a diagram showing an example of the MTF (de-focusing characteristics: image height of 100%) of the imaging lens configured by the refractive index distribution 3. From Figs 10 and 11, it can be understood that the MTF (Modulation Transfer Function) characteristics of the respective image height by the refractive index distribution 3 has sufficiently excellent values. The MTF characteristics are one of indexes for evaluating the performance of a lens. The MTF characteristics represent how accurately the lens can reproduce the contrast of a subject as spatial frequency characteristic in order to know the image formation performance of the lens.

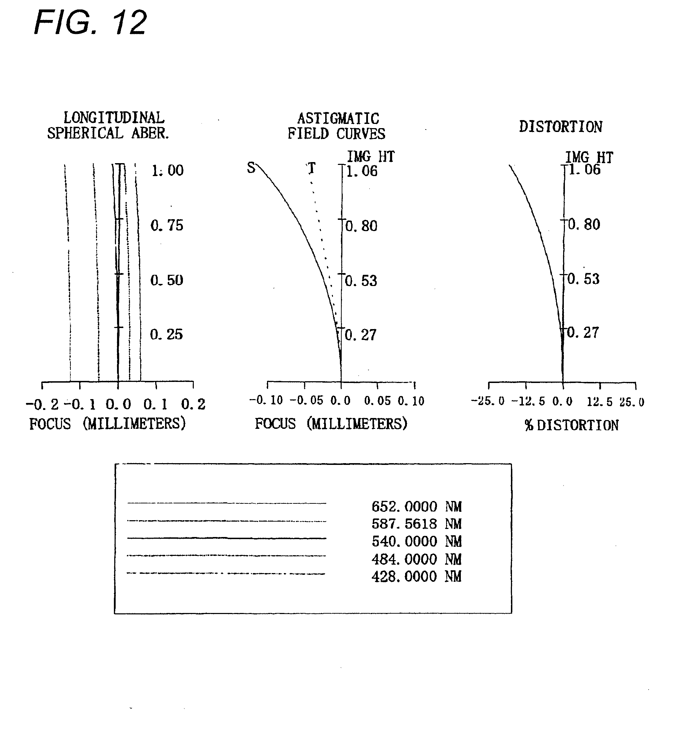

Fig. 12 is an example of the aberration diagram (axial color aberration, astigmatism, distortion) of the imaging lens configured by the refractive index distribution 3. From Fig. 12, it can be understood that the aberration of the imaging lens configured by the refractive index distribution 3 is sufficiently suppressed.

According to these results, it can be understood that the refractive index distribution 3 has the performance as the imaging lens.

Although it is supposed that the thickness of the glass of the aforesaid SELFOC lens is about 850 $\mu$m, it is difficult to realize the phase difference of Fig. 6 by the light transmissive film 10 having the film thickness of about 1$\mu$m. Thus, the aforesaid phase difference can be realized by the light transmissive film 10 having the film thickness of about 1$\mu$m when the refractive index profile is converted into a Fresnel-type refractive index profile with phase changes of 2$\pi$.

As an example of the lens using the light transmissive film 10, a lens is designed under the assumption that the radius of the lens is 1,200$\mu$m, the thickness of the light transmissive film 10 is 850$\mu$m and the focal distance of the lens is 1.2 $\mu$m. The lens is designed as the aforesaid conversion into the Fresnel-type refractive index distribution.

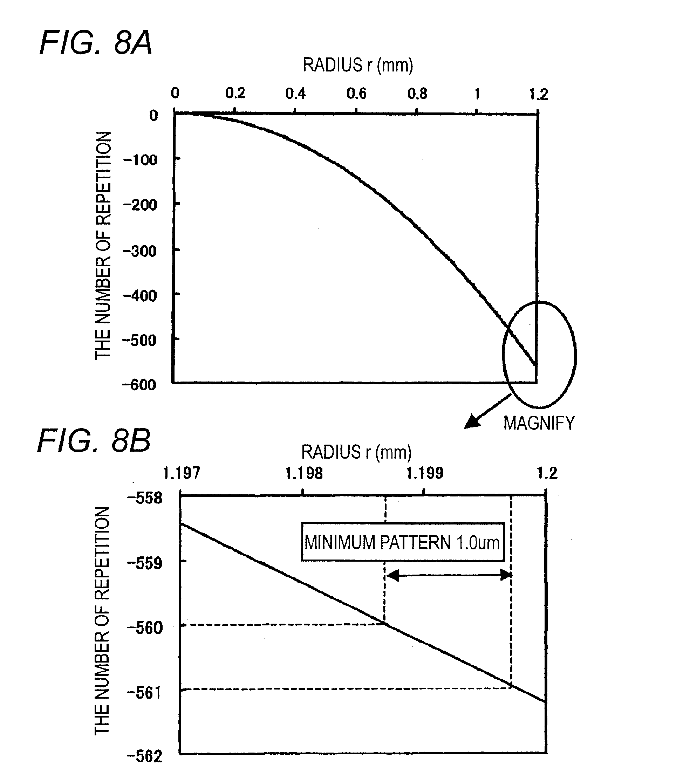

An example of the relation between the radius of the light transmissive film 10 of the lens and the number of repetition is shown in Fig. 8A. The number of repetition at the time of the conversion into the Fresnel-type refractive index distribution is $\Delta\varphi \, / \, 2\pi d$, where d is 1.2 $\mu$m. As the result of the conversion into Fresnel-type refractive index distribution, as shown in Fig. 8B, the phase difference shown in Fig. 6 can be realized by 560 times repetition of Fresnel zones and the minimum Fresnel zone is 1.0 $\mu$m. Thus, the repetition structure of about 560 is required.

In the top view of the refractive index distribution 3 by the light transmissive film 10 shown in Fig. 3, the circumferential width (also called as a line width) at the arbitrary circular light transmissive film 10 is represented by W. The circumferential width 22 of the concentric light transmissive film 10 becomes smaller sequentially toward the outer ring at the center portion of the circle. Further, the circumferential width becomes smaller sequentially toward the outer ring at each of the Fresnel zones.

When the period of the light transmissive film 10 (that is, a difference 21 between the radiuses of the outer circumference of the adjacent circular light transmissive film) is almost equal to or smaller than the wavelength of the incident light, the effective refractive index of the light can be calculated by a volume ratio between the light transmissive film 10 and the air. The greatest feature of this structure is that the refractive index can be freely controlled by merely changing the circumferential width 22.

When the period of the light transmissive film 10 is almost equal to or smaller than the wavelength of the incident light, the effective refractive index $n_{eff}$ of the light can be represented in the following expression. In this expression, W is the circumferential width 22 of the concentric circle, $T_0$ is a difference (also called a pitch) 21 of the radius of the outer circumferences between the adjacent circular light transmissive films, and $n_h$ and $n_1$ are refractive indexes of the light transmissive film 10 (high refractive index material) and the air (low refractive index material), respectively.

$$n_{eff} = \{W \ n_h + (T_0 - W) \ n_1\} \, / \, T_0 \text{------------} \quad (4)$$

As shown in Fig. 8A, the refractive index distribution 3 has a parabolic refractive-index distribution in which the refractive index is max at the center portion of the pixel and becomes smaller toward the end. The following expression (5) represents the refractive index distribution for converging incident light of a wavelength λ at a focal distance f. In the following expression, Δnmax is a difference of the refractive index between the medium on the light incident side and the lens material, that is, a difference between nh and n1, which is 0.45 in the present case.

$$\Delta n\,(x) = \Delta nmax\,[(Ax^2 + B\,x\,\sin\Theta)\,/\,2\pi + C] \quad \text{-------------} \quad (5)$$

(A, B, C : constant)

Further, in the expression (5), parameters can be set in the following manner supposing that the refractive index of the medium on the light incident side is no and the refractive index of the medium on the light outgoing side is $n_1$.

$$A = -\,(ko\,n_1)\,/\,2f \quad \text{------------------} \quad (6)$$

$$B = -\,ko\,n_1 \quad \text{-----------------} \quad (7)$$

$$ko = 2\pi\,/\,\lambda \quad \text{-----------------} \quad (8)$$

Thus, the lens can be optimized at every target focal distance and at each wavelength. In the aforesaid expression (5), the item defined as the quadratic function of the distance x from the center of the pixel represents a light converging component.

The greatest feature of such the camera module 100 is that the phase distribution can be freely determined by merely changing the circumferential width 22 of the light transmissive film 10 and so the lens function according to the camera module 100 can be realized.

Next, the explanation will be made as to an example of the manufacturing method of the camera module 100.

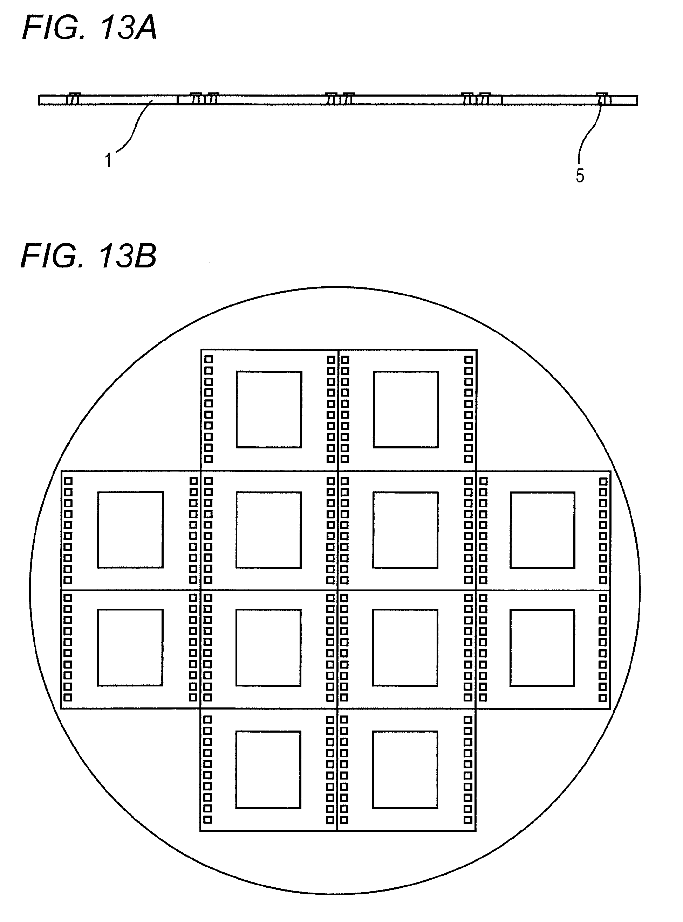

Fig. 13B is a top view of an example of a semiconductor wafer in which many solid-state imaging devices 1 are formed. Fig. 13A is a sectional diagram of the example of the semiconductor wafer. Through-hole electrodes 5 are formed so as to be coupled to electrode terminals 6 formed on the semiconductor wafer, respectively. That is, the through-hole electrodes are formed at the semiconductor wafer. The through-hole electrode 5 is formed in a manner, for example, that a through hole is formed by the dry etching and then Au or Cu or the like is buried therein by the electroplating process or the damascene.

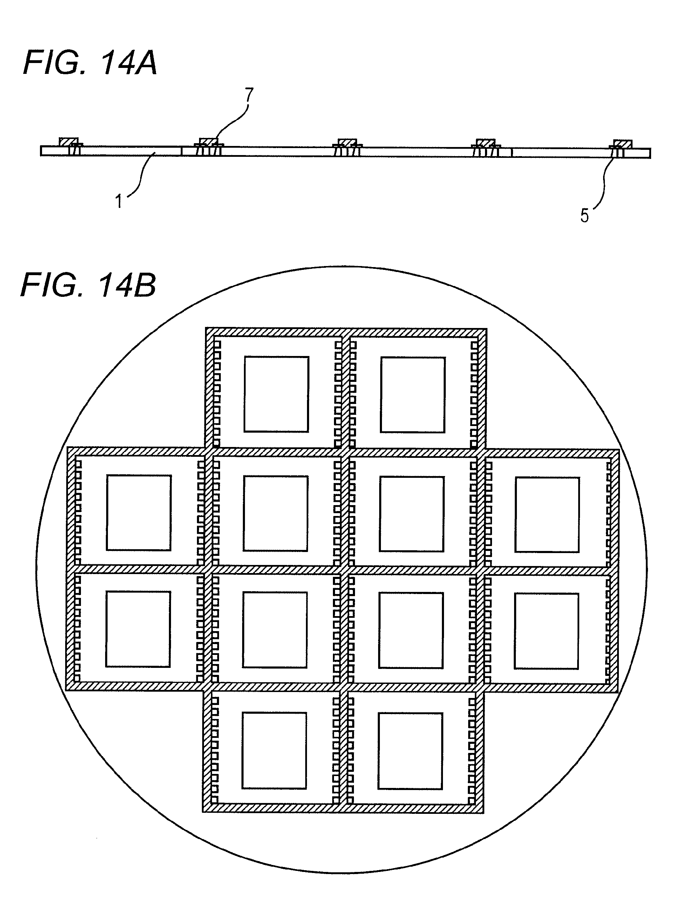

Succeedingly, as shown in Fig. 14, spacer ribs 7 are formed on the semiconductor wafer. Fig. 14A is a sectional diagram of the example of the semiconductor wafer and Fig. 14B is a top view of the example of the semiconductor wafer. In this example, the spacer ribs 7 formed by a glass with a thickness of about 1 mm is laminated. The spacer rib 7 may be quartz or heat-resistant resin. When the spacer rib 7 is formed so as not to overlap with the electrode terminal 6 formed on the semiconductor wafer, the spacer rib 7 may be formed by metal. As the bonding method, it is possible to directly bond the semiconductor wafer and the spacer rib 7 by using plasma to activate the surface. As the bonding method, an adhesive may be used.

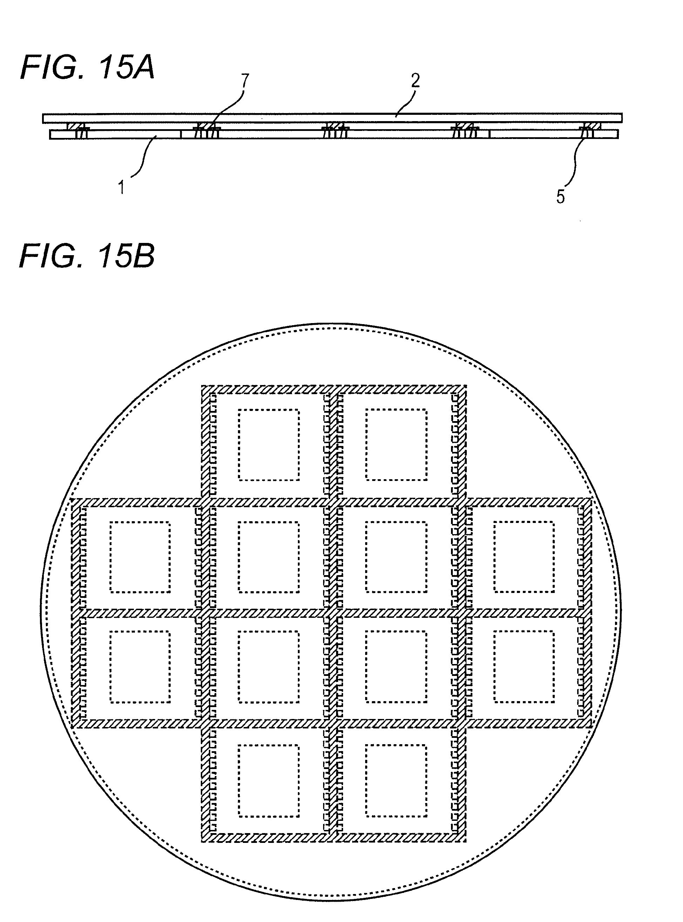

Succeedingly, as shown in Fig. 15, the transparent substrate 2 is bonded on the spacer ribs 7. Fig. 15A is a sectional diagram of the example of the semiconductor wafer and Fig. 15B is a top view of the example of the semiconductor wafer. The transparent substrate 2 is preferably a substrate having a high transmissivity in a visible light band, and so glass, quartz or transparent resin may be selected. In the present case, a glass substrate is used. Further, the glass substrate has a glass layer with a low melting point for forming the refractive index distribution 3.

According to the manufacturing processes of Figs. 13 to 15, the solid-state imaging device and the transparent substrate 2 of the imaging lens are joined to each other so as to have a gap therebetween.

Further, since the semiconductor process is employed, it is easy to fill inert gas into the gap or place the gap in a vacuum state.

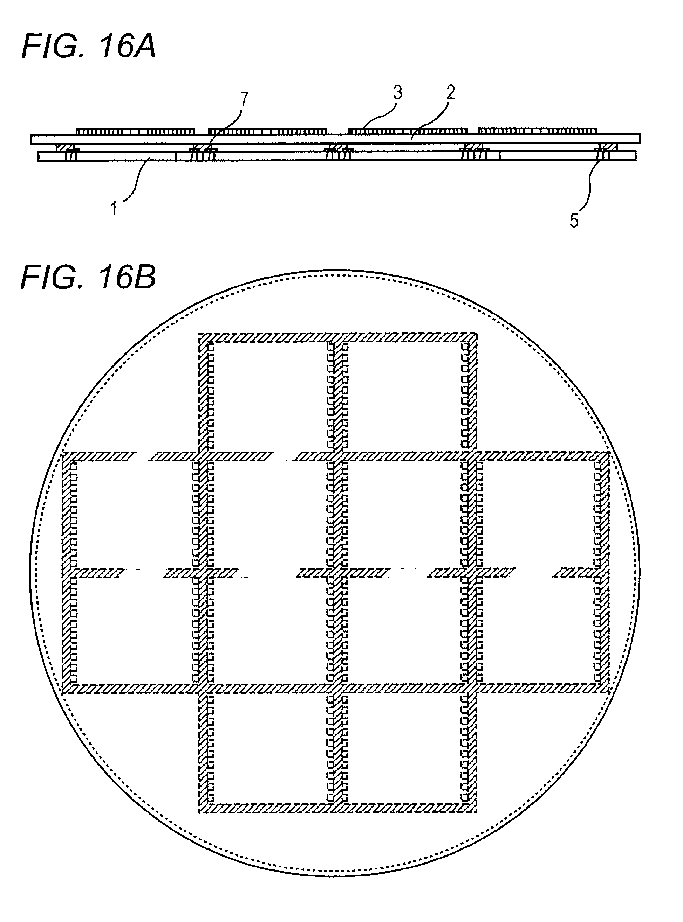

Succeedingly, as shown in Fig. 16, the refractive index distribution 3 is formed on the transparent substrate 2. Fig. 16A is a sectional diagram of the example of the semiconductor wafer and Fig. 16B is a top view of the example of the semiconductor wafer. The refractive index distribution 3 is formed so that the semiconductor wafer is heated to the temperature equal to or higher than the melting point of the glass material with the low melting point to perform the nano-imprinting. Although the glass substrate having the glass layer with the low melting point is employed in this example, the refractive index distribution 3 may be formed by pasting a thermoset resin or UV curing resin on the glass substrate to perform the nano-imprinting. Accordingly, the refractive index distribution 3 can be formed easily on the transparent substrate 2.

According to the manufacturing processes of Fig. 16, in the case of using the glass substrate having the glass layer with the low melting point, the imaging lens is configured by a substrate in which the concentric circular convex portions are formed on the surface thereof. Further, in the case of pasting the cured resin on the glass substrate, the imaging lens is configured by the substrate and the pattern of the light transmissive film 10 formed on the substrate.

When the refractive index distribution 3 is formed after bonding the transparent substrate 2 on the solid-state imaging device 1 (image sensor), the influence of strain caused at the time of bonding the substrate can be avoided.

When the substrate is the hard transparent substrate 2, the substrate may be bounded on the semiconductor wafer after forming the refractive index distribution 3 by the semiconductor processing or the like.

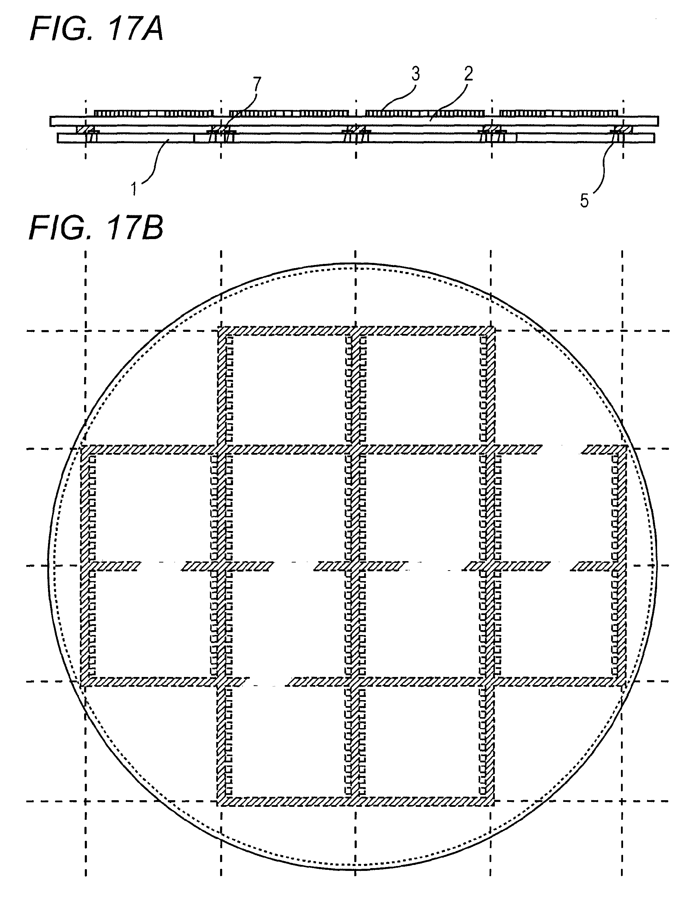

Succeedingly, as shown in Fig. 17, the semiconductor wafer is cut along dotted lines to form camera modules. Fig. 17A is a sectional diagram of the example of the semiconductor wafer and Fig. 17B is a top view of the example of the semiconductor wafer. The dicing or the laser cutting may be employed as the method of cutting the semiconductor wafer.

Thereafter, the ball bumps 4 are formed by gold on the rear surface (the surface on the opposite side of the surface where the spacer ribs 7 are formed on the semiconductor wafer). The ball bumps 4 may be formed before cutting the semiconductor wafer.

When the transparent substrate 2 is formed by glass of two or more layers having different melting points, the refractive index distribution can be formed easily on the substrate by the nano-imprinting technique or the like.

As described above, in the camera module 100 according to the invention, since the imaging lens is realized in a manner that the refractive index distribution 3 is formed by the light transmissive film with the film thickness of about 1 $\mu$m, the height can be made low. Further, since the module is formed by bonding the semiconductor wafers, the assembling process can be simplified and performed with a high accuracy, whereby the camera module with a low cost and a high performance can be realized. Furthermore, since the module can be formed with a size almost same as the solid-state imaging device (image sensor) 1, the module can be miniaturized.

Furthermore, when inorganic material or high heat resistance material is employed as the material, the camera module 100 capable of employing the reflow soldering can be realized.

Furthermore, since the gap between the solid-state imaging device and the substrate is sealed by the spacer, dust can be prevented from adhering to the image pickup portion.

Furthermore, when the gap is filled with the inactive gas or placed in a vacuum state, dew is prevented from being formed at the module even if the camera module 100 is placed under a low temperature circumstance.

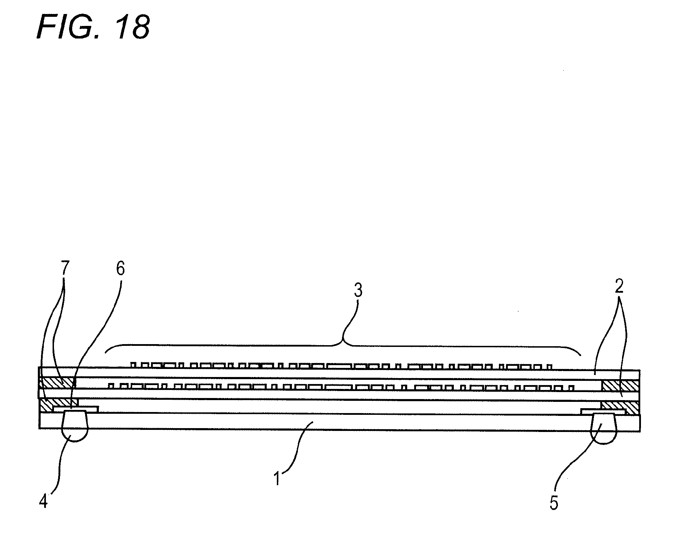

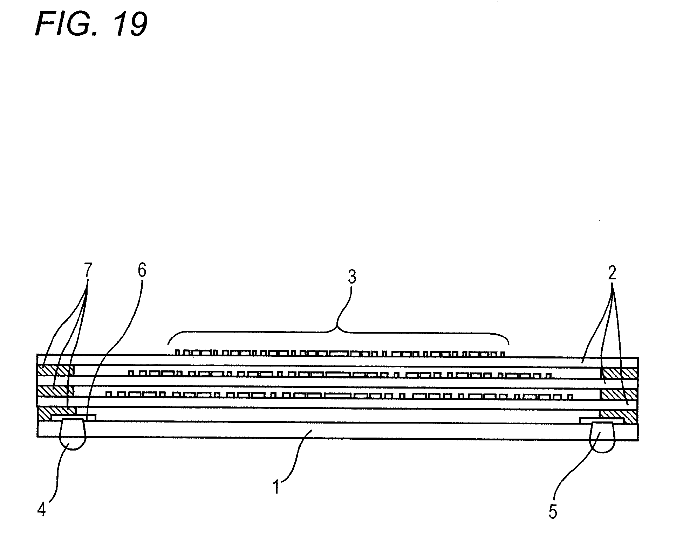

Figs. 18 and 19 are diagrams showing an example of another configuration of the camera module 100. In Figs. 18 and 19, the two or three transparent substrates 2 each forming the refractive index distribution 3 having the light transmissive film are bounded. Thus, the resolution of the imaging lens can be improved and the aberration can be suppressed. It is possible to bond three or more transparent substrates 2.

Further, in Figs. 18 and 19, the refractive index distributions formed on the transparent substrates 2 may be different. Thereby, a plurality of lens surfaces can be formed and the camera module with a high image pickup performance can be fabricated.

(Second Embodiment)

In this embodiment, the explanation will be made as to a camera module added with another function.

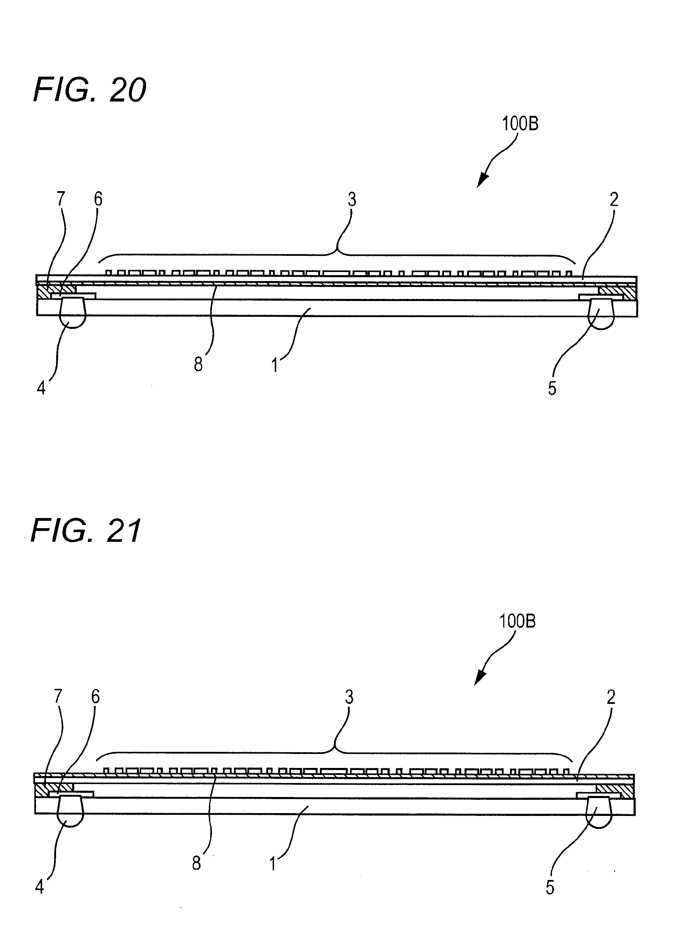

Figs. 20 and 21 are diagrams showing an example of the schematic configuration of the sectional structure a camera module 100B according to the second embodiment of the invention. The camera module 100B is applied to a camera-equipped mobile phone or the like. The camera module 100B includes an infrared ray cutoff filter 8 in addition to the constituent elements of the camera module 100 explained above.

As shown in Figs. 20 and 21, the infrared ray cutoff filter 8 is formed on the upper surface or the lower surface of the transparent substrate 2 forming the refractive index distribution 3 using the light transmissive film 10. The formation on the upper surface means that the filter is formed between the transparent substrate 2 and the pattern of the light transmissive film 10, and the formation on the lower surface means that the filter is formed on the other surface of the transparent substrate 2 opposing to the solid-state imaging device 1. Since the infrared ray cutoff filter 8 is formed on the transparent substrate 2, it is not necessary to newly attach the infrared ray cutoff filter 8 to the camera module 100B, so that the height of the module can be lowered. The infrared ray cutoff filter 8 on the upper surface or the lower surface of the transparent substrate 2 may be formed before bonding on the semiconductor wafer.

Fig. 22 is a diagram showing an example of another configuration of the camera module 100B. According to the camera module shown in Fig. 22, the two transparent substrates 2 each forming the refractive index distribution 3 using the light transmissive film are bonded, and a light shielding layer 9 is formed on the lower surface (that is, the surface of the substrate opposing to the solid-state imaging device 1) of the upper transparent substrate 2. Thus, since the light shielding layer 9 acts as a diaphragm, the capability of the imaging lens can be improved. The light shielding layer 9 may be formed by bonding on the semiconductor wafer. The light shielding layer 9 may be formed by using metal or the like. It is possible to bond the three or more transparent substrates 2.

According to such the camera module 100B, since the imaging lens is realized in a manner that the refractive index distribution 3 is formed by the light transmissive film 10 with the film thickness of about 1 μm, the height can be made low even when a plurality of the transparent substrates 2 each forming the refractive index distribution 3 are formed. Further, since the module is formed by bonding the semiconductor wafers, the assembling process can be simplified and performed with a high accuracy, whereby the camera module with a low cost and a high performance can be realized. Furthermore, since the module can be formed with a size almost same as the solid-state imaging device (image sensor) 1, the module can be miniaturized.

Further, when inorganic material or high heat resistance material is employed as the material, the camera module capable of employing the reflow soldering can be realized.

Although the invention is explained in detail with reference to the particular embodiment, it will be apparent for those skilled in the art that various changes and modifications may be possible without departing from the spirit and range of the invention.

The present application is based on Japanese Patent Application No. 2007-262395 filed on October 5, 2007, the content of which is incorporated herein by reference.

Industrial Applicability

The invention is useful for a small-sized and low-height camera module etc. and can be used for a device having an image pickup function such as a camera-equipped mobile phone.

**Claims**

1. A camera module, comprising:

    a solid-state imaging device; and
    an imaging lens which is bonded with the solid-state imaging device so as to have a gap therebetween, wherein the imaging lens has a refractive index distribution which is arranged concentrically, wherein the refractive index distribution collect an incident light on an imaging area of the solid-state imaging device.

2. The camera module according to claim1, wherein the imaging lens has a combination of a plurality of concentric circular convex structure on a substrate.

3. The camera module according to claim1, wherein the imaging lens has a combination of a plurality of concentric circular light transmissive film pattern on a substrate.

4. The camera module according to claim2, wherein the substrate includes a first glass layer and a second glass layer, wherein a melting point of the second glass layer is lower than that of the first glass layer.

5. The camera module according to claim3, wherein the imaging lens is configured by the substrate and thermoset resin pasted on the substrate.

6. The camera module according to claim3, wherein the imaging lens is configured by the substrate and UV-curing resin pasted on the substrate.

7. The camera module according to claim4 or 5, wherein the concentric circular convex structure is formed by imprinting on the surface of the imaging lens.

8. The camera module according to claim1, wherein the gap has a sealed structure.

9. The camera module according to claim8, wherein the gap is filled with inert gas.

10. The camera module according to cliam8, wherein the gap is placed in a vacuum state.

**11.** The camera module according to claim 2 or 3, wherein the imaging lens includes two or more of the substrates, and refractive index distributions formed on the respective substrates differ.

**12.** The camera module according to claim2 or 3, wherein the imaging lens includes an infrared ray cutoff filter on a surface of the substrate opposing to the solid-state imaging device.

**13.** The camera module according to claim3, wherein the imaging lens includes an infrared ray cutoff filter which is formed between the substrate and the pattern of the light transmissive film.

**14.** The camera module according to claim2 or 3, wherein the imaging lens includes a light shielding layer on a surface of the substrate opposing to the solid-state imaging device.

**15.** The camera module according to claim1, wherein through-hole electrodes are formed on the solid-state imaging device.

**16.** A method of manufacturing a camera module which includes a solid-state imaging device, and an imaging lens which is bonded with the solid-state imaging device so as to have a gap therebetween, wherein the imaging lens has a refractive index distribution which is arranged concentrically, wherein the refractive index distribution collect an incident light on an imaging area of the solid-state imaging device, the method comprising the step of:

forming the refractive index distribution of the imaging lens after bonding the substrate of the imaging lens and the solid-state imaging device.

**17.** A method of manufacturing a camera module which includes a solid-state imaging device, and an imaging lens which is bonded with the solid-state imaging device so as to have a gap therebetween, wherein the imaging lens has a refractive index distribution which is arranged concentrically, wherein the refractive index distribution collect an incident light on the imaging area of the solid-state imaging device, the method comprising the step of:

bonding the substrate of the imaging lens and the solid-state imaging device after forming the effective refractive index distribution on the substrate of the imaging lens.

**18.** The method of manufacturing a camera module according to claim 16 or 17, wherein at a time of forming the refractive index distribution of the imaging lens, the method comprising the step of: coating a resin on the substrate; and imprinting the resin.

**19.** A method of manufacturing a camera module according to claim16 or 17, wherein the substrate includes a first glass layer and a second glass layer, wherein a melting point of the second glass layer lower than that of the first glass layer, and wherein at a time of forming the refractive index distribution of the imaging lens, the method comprising the step of:

heating the substrate to a temperature equal to or higher than the melting point of the second glass layer; and imprinting the second glass layer.

FIG. 1

FIG. 2

*FIG. 3*

22(W)  21(To)

*FIG. 4*

RADIUS:1.2mm

THICKNESS:850um

FOCAL DISTANCE:1.74mm

*FIG. 5*

## FIG. 6

RADIUS r (mm)

## FIG. 7

RADIUS:1.2mm

THICKNESS:1.2um

FOCAL DISTANCE:1.74mm

*FIG. 8A*

*FIG. 8B*

*FIG. 9*

**3**

**1**

1. 1
(mm)

1. 74
(mm)

0. 85 (mm)

## FIG. 10

FREQUENCY 60 C/MM

| | | DIFFRACTION LIMIT | WAVELENGTH | WEIGHT |
|---|---|---|---|---|
| | | AXIS | 652. 0 NM | 0 |
| | T | 0.2 FIELD ( 6. 38) | | |
| | R | | 587. 6 NM | 0 |
| | T | 0.4 FIELD ( 12. 84) | | |
| | R | | 540. 0 NM | 44 |
| | T | 0.6 FIELD ( 19. 51) | | |
| | R | | 484. 0 NM | 0 |
| | T | 0.8 FIELD ( 26. 54) | | |
| | R | | 428. 0 NM | 0 |

# FIG. 11

FREQUENCY   60 C/MM

| | WAVELENGTH | WEIGHT |
|---|---|---|
| DIFFRACTION LIMIT | 652.0 NM | 0 |
| | 587.6 NM | 0 |
| ——————— T 1.0 FIELD ( 34.22) | 540.0 NM | 44 |
| — · — · — · R | 484.0 NM | 0 |
| | 428.0 NM | 0 |

# FIG. 12

LONGITUDINAL
SPHERICAL ABER.

ASTIGMATIC
FIELD CURVES

DISTORTION

| | 652. 0000 NM |
| | 587. 5618 NM |
| | 540. 0000 NM |
| | 484. 0000 NM |
| | 428. 0000 NM |

# FIG. 13A

1

5

# FIG. 13B

*FIG. 14A*

*FIG. 14B*

FIG. 15A

FIG. 15B

## FIG. 16A

## FIG. 16B

## FIG. 17A

## FIG. 17B

FIG. 18

FIG. 19

*FIG. 20*

*FIG. 21*

## FIG. 22

## FIG. 23

## INTERNATIONAL SEARCH REPORT

| International application No. |
| --- |
| PCT/JP2008/002773 |

A.   CLASSIFICATION OF SUBJECT MATTER
*H01L27/14*(2006.01)i, *G02B3/00*(2006.01)i, *H04N5/225*(2006.01)i, *H04N5/335*
(2006.01)i

According to International Patent Classification (IPC) or to both national classification and IPC

B.   FIELDS SEARCHED

Minimum documentation searched (classification system followed by classification symbols)
H01L27/14, G02B3/00, H04N5/225, H04N5/335

Documentation searched other than minimum documentation to the extent that such documents are included in the fields searched
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
| --- | --- | --- |
| A | JP 2006-324934 A  (Nikon Corp.),<br>30 November, 2006 (30.11.06),<br>Full text; all drawings<br>(Family: none) | 1-19 |
| A | JP 2006-165208 A  (Matsushita Electric<br>Industrial Co., Ltd.),<br>22 June, 2006 (22.06.06),<br>Full text; all drawings<br>(Family: none) | 1-19 |
| A | JP 2003-204053 A  (Canon Inc.),<br>18 July, 2003 (18.07.03),<br>Full text; all drawings<br>& US 2004/0012698 A1     & EP 1239519 A2<br>& TW 536833 B            & KR 10-2002-0071475 A<br>& CN 1377181 A | 1-19 |

| ☒ | Further documents are listed in the continuation of Box C. | ☐ | See patent family annex. |

| * | Special categories of cited documents: |
| "A" | document defining the general state of the art which is not considered    to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| 16 October, 2008 (16.10.08) | 28 October, 2008 (28.10.08) |

| Name and mailing address of the ISA/<br>    Japanese Patent Office | Authorized officer |
| --- | --- |
| Facsimile No. | Telephone No. |

Form PCT/ISA/210 (second sheet) (April 2007)

| **INTERNATIONAL SEARCH REPORT** | International application No. |
|---|---|
| | PCT/JP2008/002773 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 10-177643 A  (Ricoh Co., Ltd.),<br>30 June, 1998 (30.06.98),<br>Full text; all drawings<br>(Family: none) | 1-19 |

Form PCT/ISA/210 (continuation of second sheet) (April 2007)

**EP 2 197 031 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2003125294 A
- JP 2007012995 A
- JP 2007262395 A